# EUROPEAN PATENT APPLICATION

(11) **EP 3 677 608 A1**
(43) Date of publication of application: **08.07.2020**
(21) Application number: 18850063.1
(22) Date of filing: 02.08.2018
(51) Int. Cl.: C08F 297/04, B41N 1/12

(54) **BLOCK COPOLYMER FOR PHOTOSENSITIVE PRINTING PLATE MATERIAL HAVING EXCELLENT ABRASION RESISTANCE AND METHOD FOR PRODUCING SAME**

(30) Priority: 29.08.2017 JP 2017163998
(71) Applicant: Kraton JSR Elastomers K.K., Tokyo 108-0075 (JP)
(72) Inventor: TORII, Masatoshi, Tokyo 108-0075 (JP); YAMAMOTO, Shingo, Tokyo 108-0075 (JP); FUJISAKI, Hikaru, Tokyo 108-0075 (JP)
(74) Representative: Honnet, Sylvie Florence Liliane
(86) International application number: PCT/JP2018/029078
(87) International publication number: WO 2019/044369

(57) **Abstract**

Provided is a flexographic printing plate having improved abrasion resistance in addition to the appropriate elasticity (softness) required from a flexographic printing plate. The present invention is a block copolymer for a photosensitive printing plate material, the block copolymer comprising at least two polymer blocks having an aromatic vinyl monomer as a main constituent; and at least one polymer block having a conjugated diene monomer as a main constituent, wherein the amount of the aromatic vinyl monomer introduced into the polymer block having a conjugated diene block as a main constituent is 25% to 50% by weight of the content of all aromatic vinyl monomers to be bonded in the block copolymer.

## Description

### Technical Field

The present invention relates to a block copolymer for a photosensitive printing plate material having excellent abrasion resistance.

### Background Art

Flexographic printing is a printing method of using a flexible flexographic printing plate made of a resin or a rubber, which has convexities (images, characters, and the like) for ink retention formed patternwise on the surface, and transferring an ink retained on the top surface (top face) of the convexities for ink retention to an object to be printed, at a low printing pressure. This flexographic printing is mainly used for printing on a wide variety of materials such as films, labels, envelopes, heavy-duty sacks, wrapping papers, and corrugated papers, since the convexities for ink retention of the printing plate are relatively soft and may conform to the surface of a material as an object of printing.

A precursor of a flexographic printing plate is configured to include a supporting substrate having high dimensional accuracy; and a photosensitive resin layer disposed thereon, the photosensitive resin layer being curable by active energy radiation such as ultraviolet light. A face of this photosensitive resin layer is exposed to active energy radiation according to a predetermined image such as characters and diagrams to be printed, or the face is engraved by being directly exposed to laser light or the like according to this image, and through a developing treatment, that is, by removing the resin at uncured portions that are unexposed, a relief image is formed.

### Citation List

### Patent Literature

Patent Literature 1: JP 2006-104359 A

### Summary of Invention

### Problem to Be Solved

By the way, in Patent Literature 1, for the purpose of providing a block copolymer for a photosensitive printing plate material, the block copolymer having excellent laser processing characteristics, image developability, and clear printability even for small characters, and having excellent aqueous developability in a case in which a hydrophilic polymer is added; a composition of the block copolymer; and a photosensitive elastomer composition, disclosed is a block copolymer for a photosensitive printing plate material, the block copolymer including at least one polymer block having an aromatic vinyl compound as a main constituent and at least one polymer block having a conjugated diene as a main constituent, in which the aromatic vinyl compound content is included in a certain amount, the toluene-insoluble fraction and the type A hardness as measured according to JIS K6253 with a type A durometer are in certain ranges, and the vinyl bond content in the polymer block having a conjugated diene as a main constituent is included in a certain amount.

In the technology of Patent Literature 1, the hardness is set to have a certain magnitude or less so that blur or unevenness does not occur at the time of printing; however, in recent years, since the range of use applications of flexographic printing is expanding, and the number of prints is ever increasing, the productivity enhancement of printing machines has been considered as an important problem to be solved. Therefore, there has been a demand for the prolongation of the lifetime of flexographic plates, and particularly the abrasion resistance of the surface of flexographic printing plates, in addition to the characteristics developed heretofore.

### Means to Solve The Problem

In order to solve the problems described above, the present invention includes the following embodiments.
(1) A block copolymer for a photosensitive printing plate material, the block copolymer including at least two polymer blocks each having an aromatic vinyl monomer as a main constituent; and at least one polymer block having a conjugated diene monomer as a main constituent, wherein an amount of aromatic vinyl monomers introduced into the polymer block having a conjugated diene block as a main constituent is 25% to 50% by weight of the content of all aromatic vinyl monomers to be bonded in the block copolymer.
(2) The block copolymer for a photosensitive printing plate material as described in (1), wherein a toluene-insoluble fraction is 30 ppm or less.
(3) The block copolymer for a photosensitive printing plate material as described in (1) or (2), wherein a wear volume obtainable according to the method described in JIS K 6264-2 by using a specimen produced from a photosensitive composition obtained by mixing 60 parts by weight of the block copolymer, 35 parts by weight of liquid polybutadiene, 4.4 parts by weight of 1,6-hexanediol diacrylate, and 0.6 parts by weight of 2,2-dimethoxy-2-phenylacetophenone formed into a size of a thickness of 2 mm and a diameter of 120 mm, exposing both surfaces of the specimen to ultraviolet radiation for 30 minutes, and then using a Taber's abrasion testing machine with a grinding wheel H22 under the conditions of a load of 1 kg, a speed of rotation of 60 rpm, and a number of rotations of 1,000, is 35 mm³ or less.
(4) A method for producing the block copolymer as described in any one of (1) to (3), the method being a method for producing a block copolymer including at least two polymer blocks each having an aromatic vinyl monomer as a main constituent; and at least one polymer block having a conjugated diene monomer as a main constituent, the method including a step of forming a polymer block having an aromatic vinyl monomer as a main constituent; a step of subsequently forming a polymer block having a conjugated diene monomer as a main constituent; and a step of forming a polymer block having an aromatic vinyl monomer as a main constituent, wherein in the step of forming a polymer block having a conjugated diene monomer as a main constituent, an aromatic vinyl monomer is introduced in sequence or continuously in addition to the conjugated diene monomer to carried out copolymerization.
(5) The method as described in (4), wherein the step of forming a polymer block having a conjugated diene monomer as a main constituent is carried out in the presence of a randomizing agent.
(6) The method as described in (4) or (5), wherein in the step of forming a polymer block having a conjugated diene monomer as a main constituent, a mixture of an aromatic vinyl monomer and a conjugated diene monomer is introduced.

### Effects of Invention

According to the present invention, it is possible to provide a flexographic printing plate having improved abrasion resistance while maintaining appropriate elasticity (softness) that is required from a flexographic printing plate.

### Detailed Description of The Invention

Hereinafter, the present invention will be described in detail.

The block copolymer used for a photosensitive printing plate of the present invention includes at least two polymer blocks each having an aromatic vinyl monomer as a main constituent; and at least one polymer block having a conjugated diene monomer as a main constituent, wherein the amount of an aromatic vinyl monomer introduced into the block having a conjugated diene block as a main constituent is 25% by weight to 50% by weight of the content of all bonded aromatic vinyl monomers in the block copolymer, and a representative example is a compound represented by the following general formula.

Ar1-D-Ar2 (A)

In the General Formula (A) described above, Ar1 and Ar2 are polymer blocks each having an aromatic vinyl compound as a main constituent. Polymer blocks Ar1 and Ar2 may be identical to or different from each other, and examples of the aromatic vinyl monomer include styrene, t-butylstyrene, α-methylstyrene, p-methylstyrene, divinylbenzene, and 1,1-diphenylstyrene. Among these, styrene is particularly preferred.

Furthermore, in the General Formula (A), D is a polymer block having a conjugated diene monomer as a main constituent. Examples of the conjugated diene monomer for polymer block D include 1,3-butadiene, isoprene, 2,3-dimethyl-1,3-butadiene, 1,3-pentadiene, 2-methyl-1,3-pentadiene, 1,3-hexadiene, 4,5-diethyl-1,3-octadiene, 3-butyl-1,3-octadiene, and chloroprene, and among these, 1,3-butadiene and isoprene are preferred, while 1,3-butadiene is more preferred.

Furthermore, in order to suppress an increase in the hardness of the block copolymer, it is preferable that the aromatic vinyl monomer to be introduced into polymer block D having conjugated diene monomer as a main constituent is randomly introduced into polymer block D. Therefore, in the step of forming polymer block D at the time of producing the block copolymer as will be described below, it is preferable that the aromatic vinyl monomer is introduced in sequence or continuously. Here, when it is said that the aromatic vinyl monomer is randomly introduced, it is implied that when the block copolymer is analyzed by ¹H-NMR, the integrated value of one of the signals originating from a unit in which both ends of an aromatic vinyl monomers are bonded to a conjugated diene monomer is designated as RH, and the integrated value of one of the signals originating from a unit in which both ends of an aromatic vinyl monomer are bonded to an aromatic vinyl monomer is designated as BH, the value of (RH/(RH+BH))×100 is 14% or more, preferably 15% or more, and more preferably 16% or more.

In order introduce the aromatic vinyl monomer to be introduced into the polymer block D randomly into this polymer block D, it is more preferable to use a randomizing agent. The randomizing agent is not particularly limited; however, examples include ethers such as 2,2'-ditetrahydrofurylpropane, tetrahydrofuran, diethylene glycol dimethyl ether, ethylene glycol diethyl ether, and diethylene glycol dibutyl ether; amines such as triethylamine and N,N'-tetramethylethylenediamine; thioethers; phosphines; phosphoramides; alkyl benzene sulfonates; and alkoxides of potassium and sodium.

Furthermore, when the content of the aromatic vinyl monomer to be introduced into this polymer block D is too large, the hardness of the block copolymer becomes too high, and the block copolymer is not suitable for a flexographic printing plate. In contrast, when the content is too small, the effect of abrasion resistance that will be described below is lowered. Therefore, the content of the aromatic vinyl monomer is adjusted to 25% to 50% by weight of the content of all aromatic vinyl monomers to be bonded of the entire block copolymer. Meanwhile, the ratio of the content of the aromatic vinyl monomer to be introduced into polymer block D and the content of all aromatic vinyl monomers to be bonded in the entire block copolymer may be measured by a conventionally known method of subjecting a block copolymer to ozone decomposition and then measuring the residue by GPC (for example, Yasuyuki Tanaka et al., Macromolecules, Vol. 16, No. 12, 1983, pp 1925-1928).

With regard to the block copolymer according to the present embodiment, it is preferable that the content of all aromatic vinyl monomers to be bonded is 30% to 50% by weight, and the type A hardness measured according to JIS K6253 using a type A durometer is 80 or less, and preferably 75 or less. When the content of all aromatic vinyl monomers and the hardness are in these ranges, a photosensitive flexographic printing plate having both appropriate elasticity and abrasion resistance may be obtained.

The weight average molecular weight of the block copolymer is, for example, 70,000 to 180,000, preferably 100,000 to 150,000, and more preferably about 120,000 to 130,000. The weight average molecular weight is a value measured by the method that will be described below.

Furthermore, the melt flow rate (190°C, load of 2.16 kg) of the block copolymer is a property affecting the hardness of the block copolymer, and the melt flow rate is preferably 0.1 to 20, and more preferably 0.5 to 8. The melt flow rate (190°C, load of 2.16 kg) is a value measured by the method that will be described below.

The molecular weight or melt flow rate of the block copolymer is regulated by the amount of addition of a polymerization initiator, for example, sec-butyllithium.

When the toluene-insoluble fraction of the block copolymer is too large, it is not preferable on account of the cause of defects in the plate material during a washout step and the sharpness of small characters during printing. From such a viewpoint, the toluene-insoluble fraction is 30 ppm or less, preferably 20 ppm or less, and more preferably 15 ppm or less. Here, the toluene-insoluble fraction is a value measured by the method that will be described below. The toluene-insoluble fraction may be easily adjusted by employing mild conditions during solvent removal.

With regard to the abrasion resistance of the block copolymer obtained as such, a photosensitive composition is obtained by mixing 60 parts by weight of the block copolymer, 35 parts by weight of liquid polybutadiene, 4.4 parts by weight of 1,6-hexanediol diacrylate, and 0.6 parts by weight of 2,2-dimethoxy-2-phenylacetophenone, and a specimen produced from the composition into a size of a thickness of 2 mm and a diameter of 120 mm according to the method described in JIS K 6264-2 is used. Both surfaces of the specimen are exposed to ultraviolet radiation for 30 minutes, and then measurement is made using a Taber's abrasion testing machine with a grinding wheel H22 under the conditions of a load of 1 kg, a speed of rotation of 60 rpm, and a number of rotations of 1,000. The wear volume obtained as such is 35 mm³ or less, and preferably 30 mm³ or less.

A method for polymerizing the block copolymer according to the present embodiment may follow a continuous method or a coupling method, and there are no particular limitations; however, in a coupling method, since the coupling agent residue causes inferior transparency and affects developability, uncoupled components (styrenebutadiene diblock bodies) having low durability are present in a large amount, and abrasion resistance is inferior, a continuous method is preferred. By following such a continuous method, for example, an aromatic vinyl monomer is polymerized in an inactive hydrocarbon solvent using an organic alkali metal compound as a polymerization initiator, and polymer block Ar1 is formed. Next, a conjugated diene monomer is added as necessary to the reaction system containing polymer block Ar1, a conjugated diene polymer chain is formed, subsequently an aromatic vinyl monomer and a conjugated diene monomer are alternately added in small amounts, in the presence of a randomizing agent as necessary, or a mixture of the two is added in several divided portions, and thereby an aromatic vinyl compound is introduced into a conjugated diene polymer chain. Thus, the portion of polymer block D is formed. Lastly an aromatic vinyl compound is added to the reaction system containing polymer block Ar1-D, thus polymer block Ar2 is formed, subsequently polymerization is terminated with a polymerization terminating agent, and thereby a target substance (Ar1-D-Ar2) may be obtained.

Examples of the inactive hydrocarbon solvent include n-pentane, isopentane, n-hexane, isohexane, heptane, octane, methylcyclopentane, cyclohexane, methylcyclohexane, benzene, and xylene. These solvents may be used singly, or two or more kinds thereof may be used as mixtures.

Examples of the organic alkali metal compound as a polymerization initiator include an organic lithium compound and an organic sodium compound, and particularly an organic lithium compound is preferred. Specific examples of the organic lithium compound include methyllithium, ethyllithium, n-propyllithium, isopropyllithium, n-butyllithium, sec-butyllithium, and tert-butyllithium.

The polymerization reaction is usually carried out at 30°C to 100°C, and preferably 40°C to 90°C. Polymerization may be carried out under control at a certain temperature or may be carried out at an increased temperature without performing heat removal.

Furthermore, in a case in which two monomers are incorporated together at the time of forming polymer block D and a randomizing agent is used, when the amount of the randomizing agent is too small, among the co-existing two monomers, the conjugated diene monomer that is more prone to undergo reaction reacts first, and consequently there is a tendency that it becomes difficult for the aromatic vinyl monomer to be uniformly incorporated into the polymer block D. On the other hand, when the amount of the randomizing agent is too large, the amount of branch-like chains coming out from the copolymer chain due to 1,2-addition of the conjugated diene monomer becomes large, and the hardness of the block copolymer as a whole tends to increase. Therefore, it is preferable to use the randomizing agent in an amount of 0.1% to 0.5% by weight with respect to the total weight of the monomers to be reacted. Furthermore, the vinyl bond content in polymer block D may be regulated by regulating the amount of this randomizing agent.

Furthermore, a polymerization terminating agent may be used for completing the polymerization reaction, and examples of such a polymerization terminating agent include alcohols and water, for example, methanol, ethanol, 1-propanol, 2-propanol, 1-butanol, and 2-butanol.

A polymerization liquid thus obtained is subjected to solvent removal by a known method such as steam stripping, and thereby a block copolymer may be obtained. Meanwhile, additives such as an oxidation inhibitor may be added to the block copolymer as necessary.

The block copolymer of the present invention may be produced into a photosensitive composition by adding various auxiliary additive components, for example, a plasticizer, a thermal polymerization inhibitor, an ultraviolet absorber, a halation inhibitor, and a photo-stabilizer, as desired.

Regarding this photosensitive composition, in order to maintain the printing accuracy at the time of producing a photosensitive flexographic printing plate, a support of a polyester or the like may be provided on the opposite side of a relief layer formed from this composition.

A photosensitive composition that uses the block copolymer of the present invention may be prepared by various methods. For example, raw materials to be blended are mixed by dissolving them in an appropriate solvent, for example, an ester such as butyl acetate or 3-methoxybutyl acetate; a hydrocarbon such as a petroleum distillate, decalin, or toluene; a ketone such as methyl ethyl ketone or methyl isobutyl ketone; an ether such as tetrahydrofuran; or a mixed solvent obtained by mixing a chlorine system such as chloroform, tetrachlorocarbon, 1,1,1-trichloroethane, tetrachloroethylene, or trichloroethylene with an alcohol such as propanol, butanol, or pentanol and the mixture is cast into a molding flask, the solvent is evaporated, and thus the composition may be directly produced into a plate. When this plate of the photosensitive composition is subjected to heating and pressing, a layer having superior thickness accuracy is obtained. Furthermore, the photosensitive composition is kneaded using an extruder, a kneader, a BANBURY mixer, or the like, and then a sheet having a desired thickness may be formed by hot press molding, a calender treatment, or extrusion molding. The support may be closely adhered to the photosensitive composition layer by roll lamination after sheet molding. After the lamination, heating and pressing is performed, and thereby a photosensitive composition layer having high accuracy may be obtained.

Examples of an active light source that is used for photocuring this photosensitive composition include a low-pressure mercury lamp, a high-pressure mercury lamp, an ultraviolet fluorescent lamp, a carbon arc lamp, a xenon lamp, a zirconium lamp, and solar light.

Furthermore, the photosensitive composition of the present invention may also be processed using a laser. Regarding a laser oscillation device, a carbon dioxide gas laser may be mainly used.

Furthermore, a relief layer that constitutes a photosensitive flexographic printing plate using the block copolymer of the present invention is formed by a conventional method, for example, irradiating the above-mentioned photosensitive composition layer with active light rays through a transparent image carrier, thereby forming an image, and then performing a developing treatment, or by forming an image by laser processing.

Moreover, from the viewpoint of imparting desired functions, in addition, a filler such as silica, talc, or calcium carbonate, and additives such as a pigment, a crosslinking agent, and a flame retardant may be blended into the photosensitive composition.

### Examples

The present embodiments will be described in more detail by way of Examples and Comparative Examples that will be described below.

### (Example 1)

### Polymerization of block copolymer for flexographic printing plate material

A stainless steel polymerization vessel having an internal capacity of 100 liters and equipped with a jacket and a stirrer was sufficiently purged with nitrogen, subsequently 50 kg of cyclohexane and 1.285 kg of styrene were introduced thereinto, and the content was adjusted to 50°C by passing warm water in the jacket.

Next, 8.9 g of sec-butyllithium was added thereto, and thereby polymerization was initiated. After completion of styrene polymerization, while the temperature was regulated such that the content temperature would reach 70°C, 8.0 g of ethylene glycol diethyl ether was added thereto, subsequently 2.02 kg of 1,3-butadiene and 0.445 kg of styrene were slowly added thereto, and then the mixture was reacted for 30 minutes. This operation was repeated three times, and then 1.285 kg of styrene was further added thereto. After completion of the reaction, 4 ml of methanol was added thereto, and then 50 g of SUMILIZER BHT (manufactured by Sumitomo Chemical Co., Ltd.) as an oxidation inhibitor was added thereto. The reaction liquid was returned to normal temperature and normal pressure, taken out from the reaction vessel, and introduced with stirring into water, and the solvent was removed by steam distillation. Thereby, a block copolymer for a photosensitive printing plate material was obtained. Table 1 shows analysis values and physical property values of the block copolymer.

In Example 2 and Example 3, block copolymers for photosensitive printing plate materials were obtained by a technique similar to Example 1, except that the ratio of terminal styrene and mid-block styrene was changed. Table 1 shows analysis values and physical property values of the block copolymer.

The various physical properties of the block copolymers thus obtained were measured as follows.
(1) Weight average molecular weight (Mw)
   For the measurement of the weight average molecular weight, gel permeation chromatography (HLC-8320) manufactured by Tosoh Corporation was used, and Ultrabondagel E750A manufactured by Waters Corporation was used as a column. The weight average molecular weight is a value obtained by using tetrahydrofuran as a solvent, and by making measurement under measurement conditions of a temperature of 45°C, a flow rate of 1.0 ml/min, a sample concentration of 0.1% and an injection amount of 20 µl, and by calculating relative to polystyrene standards.
(2) Content of styrene to be bonded (wt%)
   The content of styrene to be bonded was calculated by a calibration curve method from the absorption intensity at a wavelength of 699 cm⁻¹ using an infrared spectroscopic analyzer (manufactured by Perkin-Elmer, Inc., Fourier transform type infrared spectroscopic analyzer).
(3) Content (wt%) of mid-block (polymer block D) styrene
   The content of mid-block styrene may be measured by a method recorded in the reference document by Tanaka et al. described above. However, herein, since it is considered that styrene as a monomer for polymerization has very high reactivity, and that substantially all of the introduced monomers are used for the polymerization reaction, for convenience, a value obtained by dividing the weight of styrene used at the time of polymerization of polymer block D by the weight of the entirety of styrene used for the production of the block copolymer was designated as the styrene content (wt%) of polymer block D.
(4) Vinyl bond content (wt%) in butadiene
   Based on the analysis results obtained in the above section (2), in which measurement was made over a measurement range of 450 to 1,200 cm⁻¹, the vinyl bond content in butadiene was calculated by a Morero method.
(5) Melt flow rate [MFR] (g/10 min)
   Measurement was made according to JIS K7210 (190°C, load of 2.16 kg) using an auto melt indexer (Model TP-404) manufactured by Tester Sangyo Co., Ltd.
(6) Toluene-insoluble fraction
   A block copolymer thus obtained was dissolved in 700 ml of toluene, subsequently a toluene-insoluble fraction was filtered through a 100-mesh iron gauze, and measurement was made.
(7) Hardness
   Measurement was made according to JIS K6253 using a type A durometer.

As a representative of Examples and Comparative Example that will be described below, in Comparative Example 2 in which the mid-block styrene content is close to the values of Examples, when the block copolymer was analyzed by ¹H-NMR, the integrated value of one of the signals originating from a unit in which both ends of an aromatic vinyl monomers were bonded to a conjugated diene monomer was designated as RH, and the integrated value of one of the signals originating from a unit in which both ends of an aromatic vinyl monomer were bonded to an aromatic vinyl monomer was designated as BH, the value of (RH/(RH+BH))×100 was calculated. The value in the Examples was 19.5%, and the value in Comparative Example 2 was 11.9%.

### Preparation of photosensitive printing plate formulation

60 parts by weight of block copolymer (1) for a photosensitive printing plate material obtained as described above, 35 parts by weight of liquid polybutadiene (Poly bd R-45HT manufacture by Idemitsu Kosan Co., Ltd.), 4.4 parts by weight of 1,6-hexanediol diacrylate, and 0.6 parts by weight of 2,2-dimethoxy-2-phenylacetophenone were kneaded in a Plastomill at 150°C.

A formulation part thus obtained was introduced into a sheet mold for a thickness of 2 mm, the sheet mold was clipped between polyester films having a thickness of 0.1 mm at the top and bottom, the assembly was heated at 130°C using a pressing machine and then cooled, and thus a sheet having a thickness of 2 mm was molded. After molding, a polyester film on one side was peeled off, both surfaces were exposed for 30 minutes using an ultraviolet exposure machine, and a flexographic plate formulation was obtained. The abrasion resistance of this photosensitive printing formulation was evaluated using a Taber's abrasion tester according to the method described in JIS K 6264-2 under the following general conditions.
- Specimen: thickness 2 mm, diameter 120 mm
- Grinding wheel: H22
- Load: 1 kg
- Speed of rotation: 60 rpm
- Number of rotations: 1,000

### (Comparative Examples 1 to 5)

### Preparation of flexographic plate formulation

An operation similar to the Examples was carried out, except that SBS as described in Table 1 was used instead of the block copolymers obtained in the Examples.

### [Table 1]

**Table 1 Evaluation of photosensitive block copolymer and photosensitive flexographic printing plate**

| | Example 1 | Example 2 | Example 3 | Comparative Example 1 | Comparative Example 2 | Comparative Example 3 | Comparative Example 4 |
|---|---|---|---|---|---|---|---|
| Weight average molecular weight (10,000) | 12.5 | 11.5 | 12.7 | 10.3 | 10.6 | 12.0 | 15.3 |
| Content of styrene to be bonded (wt%) | 39.4 | 39.4 | 39.4 | 40.1 | 43.2 | 51.8 | 16 |
| Mid-block styrene content (wt%) | 13.5 | 11.0 | 15.0 | 0 | 9.0 | 6.0 | 0 |
| Proportion (%) of mid-block styrene | 34.3 | 27.9 | 38.1 | 0 | 20.8 | 11.6 | 0 |
| Vinyl bond inclusion content (wt%) | 18.8 | 17.6 | 18.1 | 11.5 | 17.5 | 15.9 | 11.6 |
| Melt flow rate (g/10 min)¹⁾ | 4.8 | 4.9 | 5.1 | 3.2 | 4.5 | 0.6 | 5.0 |
| Toluene-insoluble fraction | 7 | 5 | 8 | 8 | 7 | 6 | 9 |
| Hardness (type A) | 70 | 75 | 72 | 87 | 84 | 97 | 54 |
| Wear volume (mm³) of flexographic plate formulation | 26 | 29 | 13 | 422 | 146 | 402 | 151 |

| | | | | | | | |
|---|---|---|---|---|---|---|---|
| 1) Measurement temperature: 190°C, load: load of 2.16 kg | | | | | | | |

Comparative Example 1 is that the content of the aromatic vinyl monomer (styrene) was increased so that the abrasion resistance could be enhanced. Meanwhile, this styrene was not introduced into the mid-block (polymer block D having butadiene as a main constituent), and as a result, the hardness became too high concomitantly with an increase in the styrene content. Furthermore, it is also insufficient from the viewpoint of abrasion resistance, and it was found that a photosensitive flexographic printing plate having both appropriate elasticity and abrasion resistance as aimed by the present invention cannot be obtained.

Comparative Example 2 is that the content of the aromatic vinyl monomer (styrene) was increased so that abrasion resistance could be enhanced, and the aromatic vinyl monomer was introduced into the mid-block (polymer block D having butadiene as a main constituent). When compared with Comparative Example 1, an improvement in the abrasion resistance was seen; however, the abrasion resistance was still insufficient, the hardness was also at a level similar to Comparative Example 1, and it was found that a photosensitive flexographic printing plate having both appropriate elasticity and abrasion resistance as aimed by the present invention cannot be obtained. It is speculated that since the amount of styrene introduced into the mid-block was insufficient, the abrasion resistance was not sufficiently increased.

Since it was still insufficient in Comparative Example 2, Comparative Example 3 is that the aromatic vinyl monomer (styrene) was introduced into the mid-block (polymer block D having butadiene as a main constituent), and also, the styrene content was increased on the whole. Similarly to Comparative Example 1, as a result, the hardness became too high concomitantly with an increase in the styrene content. Furthermore, when the block copolymer was produced into a flexographic printing plate, the printing plate became too hard and conversely became brittle, and the abrasion resistance was also poor. It is considered to be because the styrene content was too large.

Comparative Example 4 is that similarly to Comparative Example 1, the aromatic vinyl monomer (styrene) was not introduced into the mid-block (polymer block D having butadiene as a main constituent), and the content of the aromatic vinyl monomer (styrene) was adjusted to a fairly lower level compared to these Comparative Examples. In Comparative Example 4, it was found that a photosensitive flexographic printing plate which has low hardness but has still insufficient abrasion resistance, and has both appropriate elasticity and abrasion resistance as aimed by the present invention, cannot be obtained. It is considered to be because the styrene content was too small.

In Examples 1 to 3, it was found that a photosensitive flexographic printing plate having a low level of hardness and having both appropriate elasticity and abrasion resistance as aimed by the present invention may be obtained, regardless of having a styrene content that is almost at the same level as in Comparative Example 1. Furthermore, from a comparison of Comparative Examples 1 to 4, it was suggested that when the styrene content was large, and styrene in an increased amount was incorporated into the mid-block (polymer block D having butadiene as a main constituent), the increased styrene in the polymer block D contributed to abrasion resistance and could suppress an increase in hardness.

## Claims

1. A block copolymer for a photosensitive printing plate material, the block copolymer comprising at least two polymer blocks each having an aromatic vinyl monomer as a main constituent; and at least one polymer block having a conjugated diene monomer as a main constituent and having an aromatic vinyl monomer randomly inserted therein, wherein an amount of the aromatic vinyl monomer introduced in the polymer block having a conjugated diene block as a main constituent is 25% to 50% by weight of the content of all aromatic vinyl monomers to be bonded in the block copolymer, an amount of the aromatic vinyl monomers in the block copolymer is 30% to 50% by weight, and a type A hardness measured according to JIS K6253 with a type A durometer is 80 or less.

2. The block copolymer for a photosensitive printing plate material according to claim 1, wherein a toluene-insoluble fraction is 30 ppm or less.

3. The block copolymer for a photosensitive printing plate material according to claim 1 or 2, wherein a wear volume obtainable according to the method described in JIS K 6264-2 by using a specimen produced from a photosensitive composition obtained by mixing 60 parts by weight of the block copolymer, 35 parts by weight of liquid polybutadiene, 4.4 parts by weight of 1,6-hexanediol diacrylate, and 0.6 parts by weight of 2,2-dimethoxy-2-phenylacetophenone formed into a size of a thickness of 2 mm and a diameter of 120 mm, exposing both surfaces of the specimen to ultraviolet radiation for 30 minutes, and then using a Taber's abrasion testing machine with a grinding wheel H22 under the conditions of a load of 1 kg, a speed of rotation of 60 rpm, and a number of rotations of 1,000, is 35 mm³ or less.

4. A method for producing the block copolymer according to any one of claims 1 to 3, the block copolymer being a block copolymer comprising at least two polymer blocks each having an aromatic vinyl monomer as a main constituent; and at least one polymer block having a conjugated diene monomer as a main constituent, the method comprising a step of forming a polymer block having an aromatic vinyl monomer as a main constituent; a step of subsequently forming a polymer block having a conjugated diene monomer as a main constituent; and a step of forming a polymer block having an aromatic vinyl monomer as a main constituent, wherein in the step of forming a polymer block having a conjugated diene monomer as a main constituent, an aromatic vinyl monomer is introduced in sequence or continuously in addition to the conjugated diene monomer to carried out copolymerization.

5. The method according to claim 4, wherein the step of forming a polymer block having a conjugated diene monomer as a main constituent is carried out in the presence of a randomizing agent.

6. The method according to claim 4 or 5, wherein in the step of forming a polymer block having a conjugated diene monomer as a main constituent, a mixture of an aromatic vinyl monomer and a conjugated diene monomer is introduced.
